(19)

**Europäisches Patentamt**

**European Patent Office**

**Office européen des brevets**

(11)  **EP 4 502 625 A1**

(12)  **EUROPEAN PATENT APPLICATION**

(43) Date of publication:
05.02.2025  **Bulletin 2025/06**

(21) Application number: **23189752.1**

(22) Date of filing: **04.08.2023**

(51) International Patent Classification (IPC):
**G01R 15/18** (2006.01)      **H01F 5/00** (2006.01)

(52) Cooperative Patent Classification (CPC):
**G01R 15/181; H01F 5/003;** H05K 1/165

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Littelfuse Europe GmbH**
**28199 Bremen (DE)**

(72) Inventors:
• **Kucera, Pavel**
**28199 Bremen (DE)**
• **Brabetz, Ludwig**
**34125 Kassel (DE)**
• **Ayeb, Mohamed**
**34125 Kassel (DE)**
• **Horn, Markus**
**34125 Kassel (DE)**

(74) Representative: **Arnold & Siedsma**
**Bezuidenhoutseweg 57**
**2594 AC The Hague (NL)**

(54)  **FLEXIBLE PRINTED CIRCUIT ROGOWSKI COIL**

(57)      A flexible printed circuit Rogowski coil is provided and can include a flexible printed circuit board, a first connector disposed proximate a first end of the flexible printed circuit board, a second connector disposed proximate the first end of the flexible printed circuit board, a first portion of an air coil printed as a first pattern a top side of the flexible printed circuit board and connected to the first connector, and a second portion of the air coil printed as a second pattern on a bottom side of the flexible printed circuit board and connected to the second connector, the second pattern corresponding to the first pattern.

**FIG. 1**

EP 4 502 625 A1

**Description**

FIELD

The present disclosure generally relates to circuit protection devices and devices for measuring electrical current. More particularly, the present disclosure relates to a flexible printed circuit Rogowski coil.

BACKGROUND

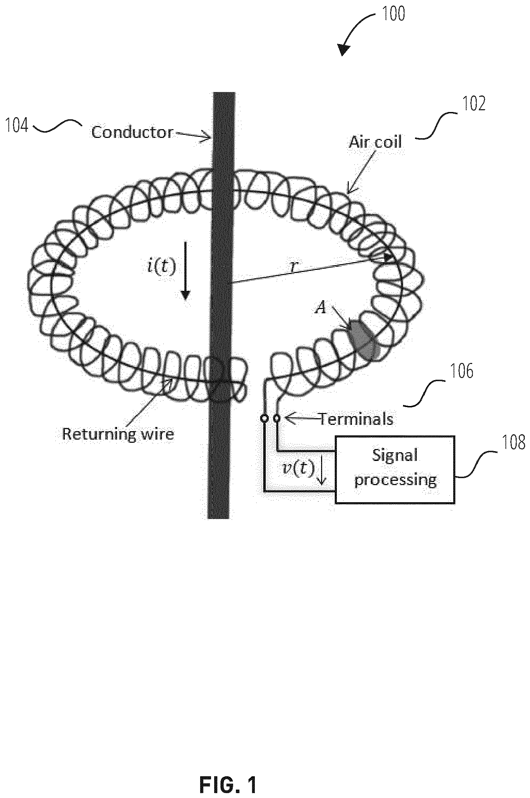

A Rogowski coil is an electrical apparatus that can be used for quantitatively and qualitatively measuring alternating current (AC) or high-speed transient or pulsing current by using both Ampere's law and Faraday's law. As seen in FIG. 1, a known Rogowski coil 100 can include an air coil 102 for measuring current passing through a conductor 104. The air coil 102 can include a toroid, helical coil with N turns and a cross-sectional area A. As seen, an end of a wire forming the air coil 102 can return through a center of the air coil 102 to a beginning of the wire so that both terminals 106 of the air coil 102 are on one side of the air coil 102. Such a configuration allows the air coil 102 to span only intended surfaces of the turns in the air coil 102, nothing more, while also wrapping around an entire circumference of the conductor 104 being measured without physically interrupting the conductor 104.

Voltage generated at the terminals 106 is governed by Faraday's law of induction as follows:

$$v(t) = -k\frac{di(t)}{dt} \tag{1}$$

where $k$ is a proportionality constant reflecting a configuration of the air coil 102 and can depend on physical dimensions A, N, and r of the air coil 102, where A is the cross-sectional area of each of the turns in the air coil 102, N is a number of the turns in the air coil 102, and $r$ is a radius of the air coil 102. A signal processing circuit 108 connected to the terminals 106 measures the voltage across the terminals 106 $v(t)$. Then, the current $i(t)$ passing through the conductor 104 is derived from the voltage $v(t)$ by integrating equation 1. The integrator can be realized using either passive or active discrete components or by a numerical integration in a computer.

Using the Rogowski coil 100 to measure the current $i(t)$ in the conductor 104 has many advantages when compared to other known methods to measure current. First, because the air coil 102 is used with no magnetic core, there are no problems with saturating a core when there is an accidental short circuit in the conductor circuit. Second, a frequency response of the air coil 102 is only limited by dimensions of the air coil 102 and capabilities of the signal processing circuit 108. Next, both of the terminals 106 on the same side of the air coil 102 provides for non-intrusive installation. In particular, the air coil 102 can be flexibly wrapped around the conductor 104, including a wire, isolated wire, busbar, and the like, without intercepting the conductor 104. Furthermore, the air coil 102 is naturally galvanically isolated from the conductor 104, and internal impedance of the air coil 102 is very low, which increases signal-to-noise ratio immunity. If the turns in the air coil 102 are identical and evenly spaced, then the voltage $v(t)$ output is proportional to a derivative of the current $i(t)$ passing through the conductor 104, thereby eliminating all external electromagnetic fields not generated by the conductor 104. Finally, positioning and orientation of the conductor 104 have negligible impact on measurement.

While possessing many advantages, it is impractical to design and use a Rogowski coil known in the art because of several limitations on a practical realization thereof. First, wiring the air coil 102 as shown in FIG. 1 is mechanically complicated and expensive in mass production. Furthermore, it is difficult to achieve evenly spaced and identical turns in the air coil 102. A nonmagnetic supporting core can be used to assist in achieving the evenly spaced and identical turns, but doing so decreases flexibility of the air coil 102 while simultaneously increasing dimensions and costs thereof. However, without the supporting core, a wire must have a large enough cross-sectional area to achieve a self-supporting configuration, but such a wire is usually expensive and inflexible, again decreasing the flexibility of the air coil 102 while simultaneously increasing the cost of the air coil 102.

In view of the above, there is a continuing, ongoing need for an improved Rogowski coil.

BRIEF SUMMARY

This Brief Summary is provided to introduce a selection of concepts in a simplified form that are further described below in the Detailed Description. This Brief Summary is not intended to identify key features or essential features of claimed subject matter or intended as an aid in determining scope of the claimed subject matter.

In some embodiments, an apparatus in accordance with the present disclosure can include a flexible printed circuit board, a first connector disposed proximate a first end of the flexible printed circuit board, a second connector disposed proximate the first end of the flexible printed circuit board, a first portion of an air coil printed as a first pattern on a top side of the flexible printed circuit board and connected to the first connector, and a second portion of the air coil printed as a second pattern on a bottom side of the flexible printed circuit board and connected to the second connector, the second pattern corresponding to the first pattern.

In some embodiments, the first portion of the air coil can include a first plurality of coils, each of the first plurality of coils being separated from and electrically connected to one another, and the second portion of the air coil can include a second plurality of coils, each of the second plurality of coils being separated from and electrically connected to one another.

In some embodiments, the first plurality of coils can be equal in number to the second plurality of coils.

In some embodiments, the first plurality of coils can be vertically aligned with the second plurality of coils.

In some embodiments, the first portion of the air coil can be connected to the second portion of the air coil through a respective via located at a respective center of each of the first and second pluralities of coils.

In some embodiments, each of the first plurality of coils can wind in a first direction, and each of the second plurality of coils can wind in the first direction.

In some embodiments, each of the first and second pluralities of coils can include an equal number of turns.

In some embodiments, an electromotive force in each of the first and second pluralities of coils can be induced by a magnetic field generated by a conductor around which the flexible printed circuit board is wrapped, and a voltage $v(t)$ measured across the first connector and the second connector can be a sum of a respective contribution of each of the first and second pluralities of coils.

In some embodiments, each of the first plurality of coils can be connected in series, and each of the second plurality of coils can be connected in series.

In some embodiments, a current $i(t)$ flowing through the conductor can be derived from the voltage $v(t)$ by integrating

$$v(t) = -k\frac{di(t)}{dt}$$

, where $k$ is a proportionality constant that can depend on physical dimensions A, N, and r of each of the first and second pluralities of coils, where A is a respective cross-sectional area of each of the turns, N is a number of the turns, and r is a respective radius of each of the first and second pluralities of coils.

In some embodiments, the apparatus can include a plastic holder supporting the flexible printed circuit board so that each of the first and second pluralities of coils is perpendicular to a magnetic field generated by a conductor passing through a center hole of the plastic holder.

In some embodiments, a plurality of bend columns can protrude from a top surface of the plastic holder, and the flexible printed circuit board can be wound around the plurality of bend columns.

In some embodiments, a plurality of spacing holes can be distributed along a length of the flexible printed circuit board, and a plurality of spacing nodes can protrude from at least some of the plurality of bend columns, wherein each of the plurality of spacing holes can fit around a respective one of the plurality of spacing nodes to secure the flexible printed circuit board in position.

In some embodiments, a method in accordance with the present disclosure can include printing a first portion of an air coil as a first pattern on a top side of a flexible printed circuit board, connecting the first portion of the air coil to a first connector disposed proximate a first end of the flexible printed circuit board, printing a second portion of the air coil as a second pattern on a bottom side of the flexible printed circuit board, the second pattern corresponding to the first pattern, connecting the second portion of the air coil to a second connector disposed proximate the first end of the flexible printed circuit board, and winding the flexible printed circuit board around a plurality of bend columns protruding from a top surface of a plastic holder so that the first portion of the air coil and the second portion of the air coil are perpendicular to a magnetic field generated by a conductor passing through a center hole of the plastic holder.

In some embodiments, the method can include physically separating a first plurality of coils in the first portion of the air coil from one another, electrically connecting the first plurality of coils to each other in series, physically separating a second plurality of coils in the second portion of the air coil from one another, and electrically connecting the second plurality of coils to each other in series.

In some embodiments, the method can include vertically aligning the first plurality of coils with the second plurality of coils.

In some embodiments, the method can include connecting the first portion of the air coil to the second portion of the air coil through a respective via located at a respective center of each of the first and second pluralities of coils.

In some embodiments, the method can include inducing an electromotive force in each of the first and second pluralities of coils by a magnetic field generated by the conductor and measuring a voltage $v(t)$ across the first connector and the second connector, wherein the voltage $v(t)$ is a sum of a respective contribution of each of the first and second pluralities of coils.

In some embodiments, a current $i(t)$ flowing through the conductor can derived from the voltage $v(t)$ by integrating

$$v(t) = -k\frac{di(t)}{dt}$$

, where $k$ is a proportionality constant that can depend on physical dimensions A, N, and r of each of the first and second pluralities of coils, where A is a respective cross-sectional area of each turn in the first and second pluralities of coils, N is a number of turns in each of the first and second pluralities of coils, and r is a respective radius of each of the first and second pluralities of coils.

In some embodiments, the method can include fitting each of a plurality of spacing holes distributed along a length of the flexible printed circuit board around a respective one of a plurality of spacing nodes protruding from at least some of the plurality of bend columns to secure the flexible printed circuit board in position.

Other technical features may be readily apparent to one skilled in the art from the following figures, descriptions, and claims.

BRIEF DESCRIPTION OF THE SEVERAL VIEWS OF THE DRAWINGS

FIG. 1 is a perspective view illustrating a Rogowski coil know in the art;

FIG. 2A is a top view illustrating a flexible printed circuit Rogowski coil in accordance with disclosed embodiments;

FIG. 2B is a bottom view illustrating a flexible printed circuit Rogowski coil in accordance with disclosed embodiments;

FIG. 3A is a perspective view illustrating a plastic holder in accordance with disclosed embodiments;

FIG. 3B is a perspective view illustrating a plastic holder with a flexible printed circuit Rogowski coil supported thereon in accordance with disclosed embodiments; and

FIG. 4 is a flow diagram illustrating a method in accordance with disclosed embodiments.

DETAILED DESCRIPTION

Exemplary embodiments of a flexible printed circuit Rogowski coil in accordance with the present disclosure will now be described more fully hereinafter with reference made to the accompany drawings. The flexible printed circuit Rogowski coil may, however, be embodied in many different forms and should not be construed as being limited to the embodiments set forth herein. Rather, these embodiments are provided so that this disclosure will convey certain exemplary aspects of a flexible printed Rogowski coil to those skilled in the art.

As disclosed herein, the flexible printed circuit Rogowski coil can be used for quantitatively and qualitatively measuring AC or high-speed transient or pulsing current flowing through a conductor. Advantageously, the flexible printed circuit Rogowski coil disclosed herein can be suitable for mass production in a cost-effective manner as compared to wired coil production.

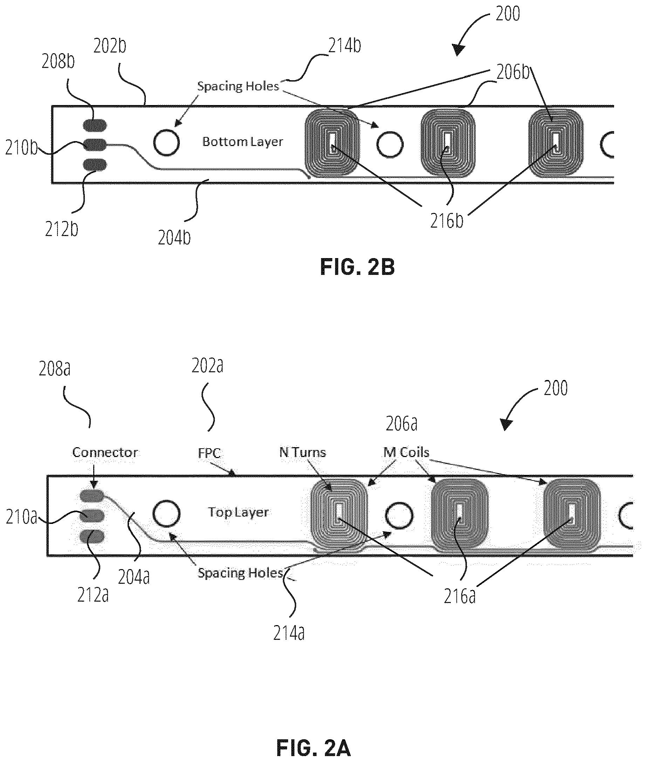

FIG. 2A is a top view of the flexible printed circuit (FPC) Rogowski coil 200 in accordance with disclosed embodiments, and FIG. 2B is a bottom view of the flexible printed circuit Rogowski coil 200 in accordance with disclosed embodiments. As seen, in some embodiments, the flexible printed circuit Rogowski coil 200 can include a flexible printed circuit board 202a, 202b, a first portion of an air coil 204a, a second portion of the air coil 204b, a first connector 208a, 208b, a second connector 210a, 210b, a third connector 212a, 212b, and a plurality of spacing holes 214a, 214b. In some embodiments, the flexible printed circuit board 202a, 202b can be double sided, and in some embodiments, the flexible printed circuit board 202a, 202b can be thin, for example, approximately 25 $\mu$m thick. Furthermore, in some embodiments, the flexible printed circuit board 202a, 202b can include a copper clad laminate. Advantageously, printing on copper clad laminate can produce distances between traces of the air coils 204a, 204b as small as 100 $\mu$m.

In some embodiments, the first connector 208a, 208b can be disposed proximate a first end of the flexible printed circuit board 202a, 202b, and the second connector 210a, 210b can be disposed proximate the first end of the flexible printed circuit board 202a, 202b. That is, the first connector 208a, 208b and the second connector 210a, 210b can be disposed proximate the same end of the flexible printed circuit board 202a, 202b. Advantageously, placing all of the connectors 208a, 208b, 210a, 210b 212a, 212b proximate the same end of the flexible printed circuit board 202a, 202b can facilitate a nonintrusive installation of the flexible printed circuit Rogowski coil 200.

In some embodiments, the first portion of the air coil 204a can be realized, for example, printed, as a first pattern on a top side of the flexible printed circuit board 202a and connected to the first connector 208a, 208b. Similarly, in some embodiments, the second portion of the air coil 204b can be realized, for example, printed, as a second pattern on a bottom side of the flexible printed circuit board 202b and connected to the second connector 210a, 210b.

In some embodiments, the first portion of the air coil 204a can include a first plurality of coils 206a, and each of the first plurality of coils 206a can be physically separated from and electrically connected to one another. Similarly, in some embodiments, the second portion of the air coil 204b can include a second plurality of coils 206b, and each of the second plurality of coils 206b can be physically separated from and electrically connected to one another. In some embodiments, each of the first plurality of coils 206a can be connected in series, and each of the second plurality of coils 206b can be connected in series.

In some embodiments, the second pattern of the second portion of the air coil 204b can correspond to the first pattern of the first portion of the air coil 204a. For example, in some embodiments, the first plurality of coils 206a can be equal in number to the second plurality of coils 206b. That is, in some embodiments, the first plurality of coils 206a can include M coils, and the second plurality of coils 206b can include M coils. In some embodiments, the first plurality of coils 206a can be vertically aligned with the second plurality of coils 206b. Furthermore, in some embodiments, each of the first plurality of coils 206a can wind in a first direction, and each of the second plurality of coils 206b can wind in the first direction. That is, a winding direction (the first direction) of the first plurality of coils 206a and the second plurality of coils 206b can be the same. In some embodiments, each of the first and second pluralities of coils 206a, 206b can include an equal number of turns. That is, in some embodiments, each of the first plurality of coils 206a can include N turns, and each of the second plurality of coils 206b can include N turns.

In some embodiments, the first portion of the air coil 204a can be connected to the second portion of the air coil 204b through a respective via 216a, 216b located at a respective center of each of the first and second pluralities of coils.

In some embodiments, the plurality of spacing holes 214a, 214b can be distributed along a length of the flexible printed circuit board 202a, 202b. For example, in some embodiments, the plurality of spacing holes 214a, 214b can be interspersed with the plurality of coils 206a, 206b along the length of the flexible printed circuit board 202a, 202b.

In accordance with disclosed embodiments, the flexible printed circuit Rogowski coil 200 can be scalable and fully configurable. For example, the first pattern of the first portion of the air coil 204a and the second pattern of the second portion of the air coil 204b can be changed, for example, with CAD tools, as needed to achieve any desired parameter of the first and second plurality of coils 206a, 206b. In this regard, at least the following parameters can be configured: thicknesses of the traces of the air coils 204a, 204b, distances of and between the traces of the air coils 204a, 204b, a number of turns (N) in the first and second pluralities of coils 206a, 206b, a number of coils (M) in the first and second pluralities of coils 206a, 206b, dimensions of the first and second pluralities of coils 206a, 206b, and the like.

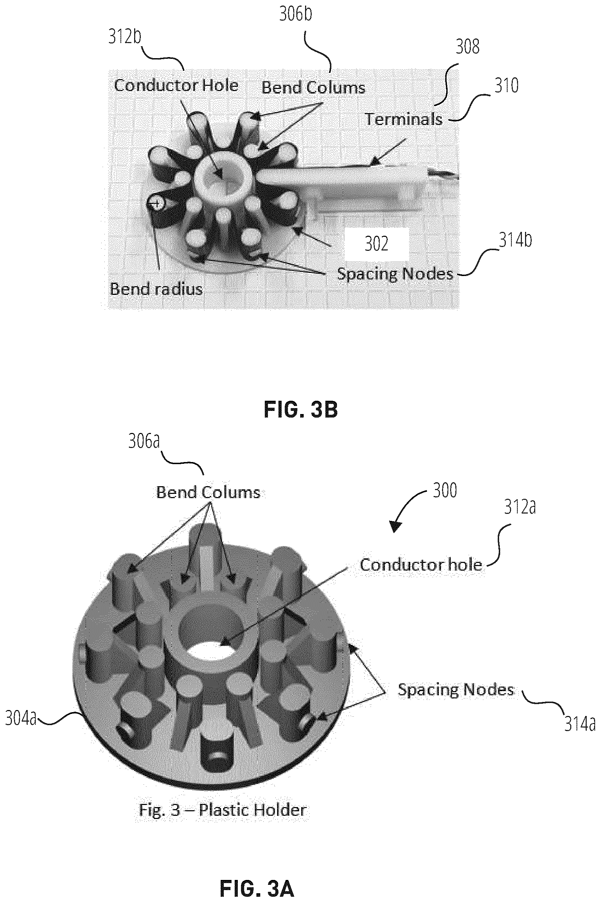

FIG. 3A is a perspective view of a plastic holder 300 in accordance with disclosed embodiments. As seen, in some embodiments, the plastic holder 300 can include a flat disc 304a, a plurality of bend columns 306a protruding, for example, in a perpendicular direction, from a top surface of the flat disc 304a, and a center hole 312a. In some embodiments, a first set of the plurality of bend columns 306a can form a first ring with a first radius around the center hole 312a, and a second set of the plurality of bend columns 306a can form a second ring with a second radius that is larger than the first radius around the center hole 312a. In some embodiments, a plurality of spacing nodes 314a can protrude from an outward facing side of at least some of the plurality of bend columns 306a, for example, from each of the second set of the plurality of bend columns 306a.

In some embodiments, the plastic holder 300 can be formed from any low-cost plastic material, and in some embodiments, the plastic holder 300 can be mass produced with plastic extrusion machinery.

As seen in FIG. 3B, in some embodiments, the plastic holder 300 can support a flexible printed circuit Rogowski coil 302 thereon, for example, the flexible printed circuit Rogowski coil 200. In some embodiments, the flexible printed circuit Rogowski coil 302 can be wound around the plurality of bend columns 306b for simple assembly. Advantageously, the plurality of bend columns 306b can ensure that a bending radius of the flexible printed circuit Rogowski coil 302 is above a minimum radius allowed for a material of the flexible printed circuit Rogowski coil 302. Furthermore, in some embodiments, each of a plurality of spacing holes of the flexible printed circuit Rogowski coil 302, for example, the plurality of spacing holes 214a, 214b, can fit around a respective one of the plurality of spacing nodes 314b to secure the flexible printed circuit Rogowski coil 302 in position. Advantageously, the plurality of spacing nodes 314b can ensure an even and symmetrical distribution of a first and second pluralities of coils of the flexible printed circuit Rogowski coil 302, for example, the first and second pluralities of coils 206a, 206b, around a circumference of the plastic holder 300.

In some embodiments, the plastic holder 300 can support the flexible printed circuit Rogowski coil 302 in a configuration that ensures each of the first and second pluralities of coils is perpendicular to a magnetic field generated by a conductor passing through the center hole 308 of the plastic holder 300.

In some embodiments, an electromotive force in each of the first and second pluralities of coils can be induced by a magnetic field generated by the conductor passing through the center hole 308, and a voltage $v(t)$ measured across terminals 308, 310, for example, the first connector 208a, 208b and the second connector 210a, 210b, can be a sum of a respective contribution of each of the first and second pluralities of coils. In some embodiments, a direction of flow of the electromotive force can be equivalent to a winding direction of the first and second pluralities of coils.

In some embodiments, a current $i(t)$ flowing through the conductor can be derived from the voltage $v(t)$ by

integrating $v(t) = -k\dfrac{di(t)}{dt}$, where $k$ is a proportionality constant that can depend on physical dimensions A, N, and r of each of the first and second pluralities of coils, where A is a respective cross-sectional area of each of the turns in the first and second pluralities of coils, N is a number of the turns in each of the first and second pluralities of coils, and r is a respective radius of each of the first and second pluralities of coils. Because the material of the flexible printed circuit Rogowski coil 302 is thin, the first and second pluralities of coils can be close enough together to effectively attenuate any electromagnetic interference cutting the first and second pluralities of coils.

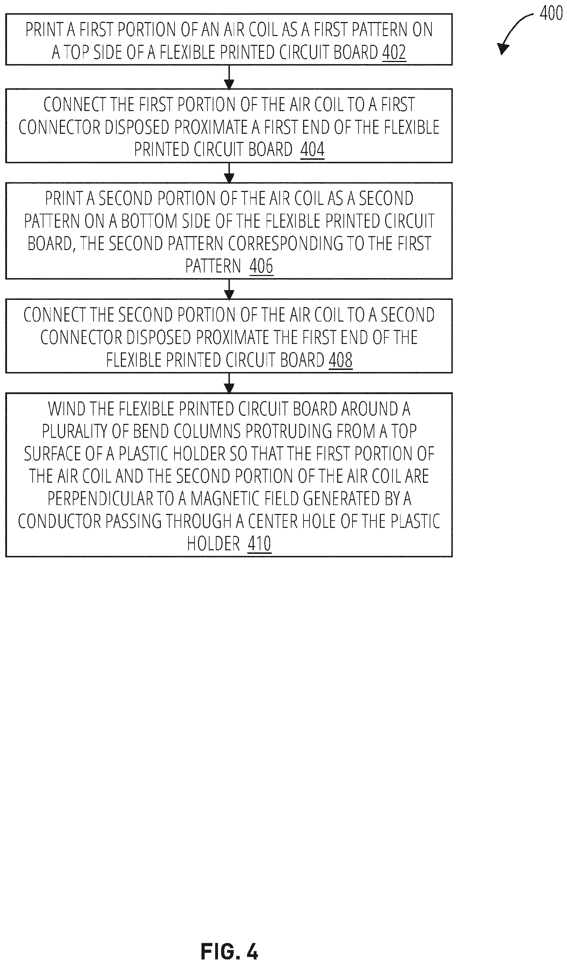

FIG. 4 is a flow diagram of a method 400 in accordance with disclosed embodiments. As seen, in some embodiments, the method 400 can include printing the first portion of the air coil 204a as the first pattern on a top side of the flexible printed circuit board 202a as in 402 and connecting the first portion of the air coil 204a to the first connector 208a disposed proximate the first end of the flexible printed circuit board 202a as in 404. The method 400 can also include printing the second portion of the air coil 204b as the second pattern on a bottom side of the flexible printed circuit board 202b as in 406 and connecting the second portion of the air coil 204b to the second connector 210b disposed proximate the first end of the flexible printed circuit board 202b as in 408. In some embodiments, the second pattern can correspond to the first pattern.

In some embodiments, printing the first portion of the air coil 204a as the first pattern on the top side of the flexible printed circuit board 202a as in 402 can include physically separating the first plurality of coils 206a in the first portion of the air coil 204a from one another and electrically connecting the first plurality of coils 206a to each other in series. Similarly, in some embodiments, printing the second portion of the air coil 204b as the second pattern on the bottom side of the flexible printed circuit board 202b as in 406 can include physically separating the second plurality of coils 206b in the second portion of the air coil 204b from one another and electrically connecting the second plurality of coils 206b to each other in series. In some embodiments, the method 400 can include vertically aligning the first plurality of coils 206a with the second plurality of coils 206b, and in some embodiments, the method 400 can include connecting the first portion of the air coil 204a to the second portion of the air coil 204b through a respective via 216a, 216b located at a respective center of each of the first and second pluralities of coils 206a, 206b.

Next, the method 400 can include winding the flexible printed circuit board 202a, 202b around the plurality of bend columns 306a, 306b of the plastic holder 300 so that the first portion of the air coil 204a and the second portion of the air coil 204b are perpendicular to the magnetic field generated by the conductor passing through the center hole 312a, 312b of the plastic holder 300 as in 410. For example, in some embodiments, the method 400 can include fitting each of the plurality of spacing holes 214a, 214b distributed along the length of the flexible printed circuit board 202a, 202b around a respective one of the plurality of spacing nodes 314a, 314b protruding from at least some of the plurality of bend columns 306a, 306b to secure the flexible printed circuit board 202a, 202b in position.

In some embodiments, when the current is flowing through the conductor, the method 400 can include inducing the electromotive force in each of the first and second pluralities of coils 206a, 206b by the magnetic field generated by the conductor and measuring the voltage $v(t)$ across the first connector 208a, 208b and the second connector 210a, 210b, wherein the voltage $v(t)$ is a sum of a respective contribution of each of the first and second pluralities of coils 206a, 206b.

In some embodiments, the current $i(t)$ flowing through the conductor can be derived from the voltage $v(t)$ by integrating $v(t) = -k\dfrac{di(t)}{dt}$, where $k$ is a proportionality constant that can depend on physical dimensions A, N, and r of each of the first and second pluralities of coils 206a, 206b, where A is a respective cross-sectional area of each of the turns in the first and second pluralities of coils 206a, 206b, N is a number of the turns in each of the first and second pluralities of coils 206a, 206b, and r is a respective radius of each of the first and second pluralities of coils 206a, 206b.

As used herein, an element or step recited in the singular and proceeded with the word "a" or "an" should be understood as not excluding plural elements or steps, unless such exclusion is explicitly recited. Furthermore, references to "one embodiment" of the present disclosure are not intended to be interpreted as excluding the existence of additional embodiments that also incorporate the recited features.

While the present disclosure makes reference to certain embodiments, numerous modifications, alterations and changes to the described embodiments are possible without departing from the sphere and scope of the present disclosure, as defined in the appended claims. Accordingly, it is intended that the present disclosure not be limited to the described embodiments, but that it has the full scope defined by the language of the following claims and equivalents thereof.

**Claims**

1. An apparatus comprising:

   a flexible printed circuit board;
   a first connector disposed proximate a first end of the flexible printed circuit board;
   a second connector disposed proximate the first end of the flexible printed circuit board;
   a first portion of an air coil printed as a first pattern on a top side of the flexible printed circuit board and connected to the first connector; and
   a second portion of the air coil printed as a second pattern on a bottom side of the flexible printed circuit board and connected to the second connector, the second pattern corresponding to the first pattern.

2. The apparatus of claim 1, wherein the first portion of the air coil includes a first plurality of coils, each of the first plurality of coils being separated from and electrically connected to one another, and wherein the second portion of the air coil includes a second plurality of coils, each of the second plurality of coils being separated from and electrically connected to one another.

3. The apparatus of claim 2, wherein the first plurality of coils is equal in number to the second plurality of coils.

4. The apparatus of claim 2 or 3, wherein the first plurality of coils is vertically aligned with the second plurality of coils.

5. The apparatus of any of the claims 2-4, wherein the first portion of the air coil is connected to the second portion of the air coil through a respective via located at a respective center of each of the first and second pluralities of coils.

6. The apparatus of any of the claims 2-5, wherein each of the first plurality of coils winds in a first direction, and wherein each of the second plurality of coils winds in the first direction.

7. The apparatus of any of the claims 2-6, wherein each of the first and second pluralities of coils includes an equal number of turns.

8. The apparatus of any of the claims 2-7, wherein, an electromotive force in each of the first and second pluralities of coils is induced by a magnetic field generated by a conductor around which the flexible printed circuit board is wrapped, and wherein a voltage $v(t)$ measured across the first connector and the second connector is a sum of a respective contribution of each of the first and second pluralities of coils.

9. The apparatus of any of the claims 2-8, wherein each of the first plurality of coils is connected in series, and wherein each of the second plurality of coils is connected in series.

10. The apparatus of claim 8 or 9, wherein a current $i(t)$ flowing through the conductor is derived from the voltage $v(t)$ by integrating $$v(t) = -k\frac{di(t)}{dt}$$, where $k$ is a proportionality constant dependent on physical dimensions A, N, and r of each of the first and second pluralities of coils, where A is a respective cross-sectional area of each of the turns, N is a number of the turns, and r is a respective radius of each of the first and second pluralities of coils.

11. The apparatus of any of the claims 2-10, further comprising:

    a plastic holder supporting the flexible printed circuit board so that each of the first and second pluralities of coils is perpendicular to a magnetic field generated by a conductor passing through a center hole of the plastic holder, preferably further comprising:

       a plurality of bend columns protruding from a top surface of the plastic holder,
       wherein the flexible printed circuit board is wound around the plurality of bend columns,
       more preferably further comprising:

          a plurality of spacing holes distributed along a length of the flexible printed circuit board; and
          a plurality of spacing nodes protruding from at least some of the plurality of bend columns,
          wherein each of the plurality of spacing holes fits around a respective one of the plurality of spacing nodes to secure the flexible printed circuit board in position.

12. A method comprising:

printing a first portion of an air coil as a first pattern on a top side of a flexible printed circuit board;
connecting the first portion of the air coil to a first connector disposed proximate a first end of the flexible printed circuit board;
printing a second portion of the air coil as a second pattern on a bottom side of the flexible printed circuit board, the second pattern corresponding to the first pattern;
connecting the second portion of the air coil to a second connector disposed proximate the first end of the flexible printed circuit board; and
winding the flexible printed circuit board around a plurality of bend columns protruding from a top surface of a plastic holder so that the first portion of the air coil and the second portion of the air coil are perpendicular to a magnetic field generated by a conductor passing through a center hole of the plastic holder.

13. The method of claim 12, further comprising:

physically separating a first plurality of coils in the first portion of the air coil from one another;
electrically connecting the first plurality of coils to each other in series;
physically separating a second plurality of coils in the second portion of the air coil from one another; and
electrically connecting the second plurality of coils to each other in series.

14. The method of claim 13, further comprising one or more of the following:

- vertically aligning the first plurality of coils with the second plurality of coils;
- connecting the first portion of the air coil to the second portion of the air coil through a respective via located at a respective center of each of the first and second pluralities of coils;
- inducing an electromotive force in each of the first and second pluralities of coils by a magnetic field generated by the conductor; and
measuring a voltage $v(t)$ across the first connector and the second connector, wherein the voltage $v(t)$ is a sum of a respective contribution of each of the first and second pluralities of coils;
- fitting each of a plurality of spacing holes distributed along a length of the flexible printed circuit board around a respective one of a plurality of spacing nodes protruding from at least some of the plurality of bend columns to secure the flexible printed circuit board in position.

15. The method of claims 13 or 14, wherein a current $i(t)$ flowing through the conductor is derived from the voltage $v(t)$ by integrating $v(t) = -k\dfrac{di(t)}{dt}$ , where $k$ is a proportionality constant dependent on physical dimensions A, N, and r of each of the first and second pluralities of coils, where A is a respective cross-sectional area of each turn in the first and second pluralities of coils, N is a number of turns in each of the first and second pluralities of coils, and r is a respective radius of each of the first and second pluralities of coils.

**FIG. 1**

EP 4 502 625 A1

FIG. 2B

FIG. 2A

10

**FIG. 3B**

Fig. 3 – Plastic Holder

**FIG. 3A**

400

PRINT A FIRST PORTION OF AN AIR COIL AS A FIRST PATTERN ON A TOP SIDE OF A FLEXIBLE PRINTED CIRCUIT BOARD 402

CONNECT THE FIRST PORTION OF THE AIR COIL TO A FIRST CONNECTOR DISPOSED PROXIMATE A FIRST END OF THE FLEXIBLE PRINTED CIRCUIT BOARD 404

PRINT A SECOND PORTION OF THE AIR COIL AS A SECOND PATTERN ON A BOTTOM SIDE OF THE FLEXIBLE PRINTED CIRCUIT BOARD, THE SECOND PATTERN CORRESPONDING TO THE FIRST PATTERN 406

CONNECT THE SECOND PORTION OF THE AIR COIL TO A SECOND CONNECTOR DISPOSED PROXIMATE THE FIRST END OF THE FLEXIBLE PRINTED CIRCUIT BOARD 408

WIND THE FLEXIBLE PRINTED CIRCUIT BOARD AROUND A PLURALITY OF BEND COLUMNS PROTRUDING FROM A TOP SURFACE OF A PLASTIC HOLDER SO THAT THE FIRST PORTION OF THE AIR COIL AND THE SECOND PORTION OF THE AIR COIL ARE PERPENDICULAR TO A MAGNETIC FIELD GENERATED BY A CONDUCTOR PASSING THROUGH A CENTER HOLE OF THE PLASTIC HOLDER 410

**FIG. 4**

## EP 4 502 625 A1

| | Europäisches Patentamt European Patent Office Office européen des brevets | **EUROPEAN SEARCH REPORT** | Application Number EP 23 18 9752 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | JP 2023 020258 A (KYUSHU INST TECH)<br>9 February 2023 (2023-02-09)<br>* figures 5-10 * | 1<br>2-10<br>11-15 | INV.<br>G01R15/18<br>H01F5/00 |
| X<br>Y<br>A | JP 2008 241480 A (MATSUSHITA ELECTRIC WORKS LTD) 9 October 2008 (2008-10-09)<br>* figures 1-3 * | 1<br>2-10<br>11-15 | |
| Y | US 2015/377929 A1 (WANG RUXI [US] ET AL)<br>31 December 2015 (2015-12-31)<br>* figures 2-4 * | 2-10 | |
| Y | US 2004/178875 A1 (SAITO MINORU [JP])<br>16 September 2004 (2004-09-16)<br>* figures 12,14 * | 2-10 | |
| Y | US 2015/015244 A1 (RAY WILLIAM FREDERICK [GB] ET AL) 15 January 2015 (2015-01-15)<br>* paragraphs [0003] - [0005]; figure 1 * | 2-10 | TECHNICAL FIELDS SEARCHED (IPC) |
| A | US 2014/333284 A1 (DAMES ANDREW NICHOLAS [GB] ET AL) 13 November 2014 (2014-11-13)<br>* figure 4 * | 1-15 | G01R<br>H05K<br>H01F |
| A | US 2016/097794 A1 (LINT JAMES DOUGLAS [US] ET AL) 7 April 2016 (2016-04-07)<br>* figure 2 * | 1-15 | |
| A | WO 2023/012609 A1 (ELECTROCERAMICA S A [RO]) 9 February 2023 (2023-02-09)<br>* figures 2A-4F * | 1-15 | |

The present search report has been drawn up for all claims

| Place of search | Date of completion of the search | Examiner |
|---|---|---|
| Munich | 5 January 2024 | Schindler, Martin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 9752

This annex lists the patent family members relating to the patent documents cited in the above-mentioned European search report.
The members are as contained in the European Patent Office EDP file on
The European Patent Office is in no way liable for these particulars which are merely given for the purpose of information.

05-01-2024

| Patent document cited in search report | | | Publication date | Patent family member(s) | | Publication date |
|---|---|---|---|---|---|---|
| JP 2023020258 | A | | 09-02-2023 | NONE | | |
| JP 2008241480 | A | | 09-10-2008 | JP 4798041 B2 | | 19-10-2011 |
| | | | | JP 2008241480 A | | 09-10-2008 |
| US 2015377929 | A1 | | 31-12-2015 | CN 105277770 A | | 27-01-2016 |
| | | | | EP 2960661 A1 | | 30-12-2015 |
| | | | | US 2015377929 A1 | | 31-12-2015 |
| US 2004178875 | A1 | | 16-09-2004 | CN 1497622 A | | 19-05-2004 |
| | | | | FR 2845197 A1 | | 02-04-2004 |
| | | | | JP 2004119926 A | | 15-04-2004 |
| | | | | US 2004178875 A1 | | 16-09-2004 |
| US 2015015244 | A1 | | 15-01-2015 | CN 104094125 A | | 08-10-2014 |
| | | | | EP 2810088 A1 | | 10-12-2014 |
| | | | | ES 2709100 T3 | | 15-04-2019 |
| | | | | KR 20140123567 A | | 22-10-2014 |
| | | | | PL 2810088 T3 | | 28-06-2019 |
| | | | | US 2015015244 A1 | | 15-01-2015 |
| | | | | WO 2013114137 A1 | | 08-08-2013 |
| US 2014333284 | A1 | | 13-11-2014 | AU 2012356406 A1 | | 19-06-2014 |
| | | | | CN 104145186 A | | 12-11-2014 |
| | | | | EP 2795347 A1 | | 29-10-2014 |
| | | | | ES 2552184 T3 | | 26-11-2015 |
| | | | | PL 2795347 T3 | | 29-01-2016 |
| | | | | RU 2014125260 A | | 20-02-2016 |
| | | | | US 2014333284 A1 | | 13-11-2014 |
| | | | | WO 2013093516 A1 | | 27-06-2013 |
| | | | | ZA 201403905 B | | 25-11-2015 |
| US 2016097794 | A1 | | 07-04-2016 | BR 112012016902 A2 | | 20-04-2021 |
| | | | | CN 102770772 A | | 07-11-2012 |
| | | | | EP 2521922 A1 | | 14-11-2012 |
| | | | | TW 201140076 A | | 16-11-2011 |
| | | | | TW 201435355 A | | 16-09-2014 |
| | | | | US 2011148561 A1 | | 23-06-2011 |
| | | | | US 2016097794 A1 | | 07-04-2016 |
| | | | | WO 2011097045 A1 | | 11-08-2011 |
| WO 2023012609 | A1 | | 09-02-2023 | NONE | | |

EPO FORM P0459

For more details about this annex : see Official Journal of the European Patent Office, No. 12/82